(19) Europäisches Patentamt
European Patent Office
Office européen des brevets

(11) **EP 4 633 036 A1**

(12) **EUROPEAN PATENT APPLICATION**

(43) Date of publication:
**15.10.2025 Bulletin 2025/42**

(21) Application number: **25159926.2**

(22) Date of filing: **25.02.2025**

(51) International Patent Classification (IPC):
**H03F 1/02** (2006.01)  **H01P 5/12** (2006.01)
**H03F 1/56** (2006.01)  **H03F 3/195** (2006.01)
**H03F 3/24** (2006.01)

(52) Cooperative Patent Classification (CPC):
**H03F 1/0288; H01P 5/12; H03F 1/565; H03F 3/195;**
**H03F 3/245;** H03F 2200/222; H03F 2200/318;
H03F 2200/387; H03F 2200/451

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **08.04.2024 US 202418629766**

(71) Applicant: **NXP USA, Inc.**
**Austin, TX 78735 (US)**

(72) Inventors:
• **MAALOUF, Elie A.**
**5656AG Eindhoven (NL)**
• **FRASER, Michael Lee**
**5656AG Eindhoven (NL)**
• **WU, Yu-Ting David**
**5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **DUAL PURPOSE POWER SPLITTER FOR DOHERTY POWER AMPLIFIER**

(57) An amplifier device is presented that may include an integrated passive device (IPD). The IPD includes a substrate and a power splitter on the substrate. The power splitter includes a power splitter input terminal, a first power splitter output terminal having a first output impedance, and a second power splitter output terminal having a second output impedance that is different from the first output impedance. The power splitter is an asymmetric Wilkinson power splitter configured to receive a first signal at the power splitter input terminal, divide the first signal into a first output signal and a second output signal, output the first output signal at the first power splitter output terminal, and output the second output signal at the second power splitter output terminal.

FIG. 5B

EP 4 633 036 A1

**Description**

## FIELD OF THE INVENTION

Embodiments of the subject matter described herein relate generally to multi-stage radio frequency (RF) amplifiers, and more particularly to signal splitters and impedance matching networks circuits for multi-stage RF amplifiers.

## BACKGROUND

Wireless communication systems employ power amplifiers for increasing the power of radio frequency (RF) signals. In a wireless communication system, a power amplifier forms a portion of the last stage in a transmission chain before provision of the amplified signal to an antenna for radiation over the air interface. High gain, high linearity, stability, and a high level of power-added efficiency are characteristics of a desirable amplifier in such a wireless communication system.

One amplifier configuration used in the transmission of RF signals is the Doherty power amplifier. A two-way Doherty power amplifier typically includes a signal splitter, parallel-coupled carrier and peaking amplifier paths, a combining node, and an impedance inverter and Doherty load modulation line (or "impedance inverter line"). Each of the carrier and peaking amplifier paths may include multiple serially coupled amplifiers, typically including a driver amplifier that has a relatively low gain and a final-stage amplifier that functions as an output power amplifier with relatively high gain.

To provide adequate impedance matching between the driver and final-stage amplifiers, inter-stage matching networks are included between the driver and final-stage amplifiers. These inter-stage matching networks typically include relatively-large networks of passive components, including resistors, inductors, and capacitors, that operate to match the output impedance of the driver amplifier to the input impedance of the final-stage amplifier in each of the carrier and peaking amplifier paths. In single-driver Doherty power amplifier configurations, a single driver amplifier supplies an amplified version of an input RF signal to an input of the power splitter.

## BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:

FIG. 1 is a simplified schematic diagram of a Doherty power amplifier.

FIG. 2 depicts a schematic of a Doherty power amplifier in which a single driver amplifier is used to amplify an RF input signal before the signal is split to supply carrier and peaking input signals to parallel carrier and peaking paths.

FIG. 3 is a top view of a Doherty power amplifier module.

FIG. 4 is a diagram illustrating a conceptual design of an embodiment of an asymmetric Wilkinson power splitter implemented as a combination of microstrip transmission lines.

FIG. 5A is a schematic depicting an embodiment of a circuit schematic of an asymmetric Wilkinson power splitter configured for use in an asymmetric Doherty power amplifier.

FIG. 5B depicts an embodiment of an integrated passive device layout for a Wilkinson power splitter configured in accordance with the circuit of FIG. 5A.

FIG. 5C is a schematic depicting an alternate embodiment of circuit schematic for an asymmetric Wilkinson power splitter configured for use in an asymmetric Doherty power amplifier.

FIG. 6 is a top view of a Doherty power amplifier module incorporating the Wilkinson power splitter of FIG. 5A.

## DETAILED DESCRIPTION OF THE ILLUSTRATED EMBODIMENTS

Doherty power amplifiers are dual-path amplifiers that include a carrier amplifier path and a peaking amplifier path. A power splitter receives an input RF signal, splits that signal into first and second RF signals (i.e., carrier and peaking signals) based on the input RF signal that are fed, respectively, into the carrier amplifier path and the peaking amplifier path. Embodiments of Doherty power amplifiers include driver amplifier stages that may be located along each of the carrier amplifier path and the peaking amplifier path. Alternatively, a single driver amplifier stage may be located in the lineup before the power splitter. Either way, the carrier and peaking amplifier paths also include final-stage amplifiers (i.e., carrier and peaking amplifiers). In embodiments in which each of the carrier and peaking amplifier paths includes a driver amplifier stage, interstage impedance matching networks are provided in the lineup between the driver and final-stage amplifiers. Alternatively, when the driver amplifier stage is located in the lineup before the power splitter, interstage matching networks may be provided between the power splitter outputs and the final-stage amplifiers. This generally provides adequate impedance matching. In typical Doherty power amplifiers, the power splitter and the inter-stage matching networks are provided by distinct circuit components. However, as explained below, these distinct components take up a large amount of space within the amplifier package. Further, insertion losses associated with distinct inter-stage matching networks may decrease amplifier efficiency. The present disclosure provides a more space-efficient Doherty power amplifier implementation in which the power splitter functionality and the inter-stage matching network functionalities are provided by a single circuit. This improvement can result in a significant reduction in overall size and cost of the Doherty power amplifier and can improve performance and efficiency.

In a Doherty power amplifier, each amplification stage of the carrier amplifier path and the peaking amplifier path may be implemented as a power transistor. For example, each driver amplifier, final-stage carrier amplifier, and final-stage peaking amplifier may be implemented using a distinct power transistor. Using nomenclature typically applied to field effect transistors (FETs), the carrier amplifier transistor and the peaking amplifier transistor each may include a control terminal (e.g., a gate) configured to receive an input RF signal, and two current conducting terminals (e.g., a drain terminal and a source terminal). In some configurations, each source terminal is coupled to a ground reference node, and the amplified carrier and peaking signals are output at the drain terminals of the carrier amplifier transistor and the peaking amplifier transistor, respectively. In some embodiments, the drain terminal of the peaking amplifier transistor may serve as a combining node for the amplified RF signals produced by the carrier and peaking amplifiers. In other embodiments, the combining node may be physically and electrically separated from the drain terminal of the peaking amplifier transistor.

The Figures and the below description illustrate and discuss an embodiment of a two-way "non-inverted" Doherty power amplifier that includes a carrier amplifier and a single peaking amplifier, where the RF signal provided at the peaking amplifier input lags the RF signal provided at the carrier amplifier input by about 90 degrees, and a phase shift and inverter line assembly functions to apply a phase shift to the amplified carrier signal before it is combined with the amplified peaking signal at the combining node. In some embodiments, a phase shift and impedance inverter line assembly is implemented in a "90-0" Doherty power amplifier, in which about 90 degrees of phase shift is applied to the amplified carrier signal before it reaches the combining node (e.g., at the peaking amplifier transistor drain terminal), whereas no substantial phase shift is applied to the peaking signal before it reaches the combining node.

Although the Figures and the below description focus on 90-0 Doherty power amplifier embodiments, in other embodiments, other phase shift and impedance inverter line assemblies may be implemented. For example, in a "90-180" Doherty power amplifier, a phase shift and impedance inverter line assembly applies phase shifts of about 90 degrees and about 180 degrees, respectively, between the drain terminals of both the carrier and peaking amplifiers and the combining node. In still another example, a "270-90" Doherty power amplifier includes a phase shift and impedance inverter line assembly in which about 270 degrees of phase shift is applied to the amplified carrier signal before it reaches the combining node, whereas about 90 degrees of phase shift is applied to the amplified peaking signal before it reaches the combining node. In such embodiments, a first phase shift and impedance inverter line assembly with a first electrical length may be coupled between the carrier amplifier output and the combining node, and a second phase shift and impedance inverter line assembly with a second and different electrical length may be coupled between the peaking amplifier output and the combining node. Either way, phase shifts are designed into the phase shift and impedance inverter line assemblies in order to ensure that the amplified carrier and peaking signals combine in phase at the combining node.

Further, whereas the Figures and the below description focus on non-inverted Doherty power amplifier embodiments, other embodiments include "inverted" 90-0, 90-180, or 270-90 Doherty power amplifiers, in which the RF signal provided at the carrier amplifier input lags the RF signal provided at the peaking amplifier input by about 90 degrees, and corresponding phase shifts are applied by a phase shift and impedance inverter line assembly to the amplified peaking signal before it is combined in phase with the amplified carrier signal at the combining node.

In typical Doherty power amplifier configurations, the carrier and peaking amplifier paths typically each include serially-coupled driver and final-stage amplifiers that, together, generate about 30 - 35 decibels (dB) of signal gain. Many such amplifiers are implemented using gallium nitride on silicon carbide (GaN on SiC) technologies for the transistor of both the driver and final amplifier stages. Other amplifiers may be implemented using silicon-based transistor technologies for either or both the driver and/or final-stage amplifiers.

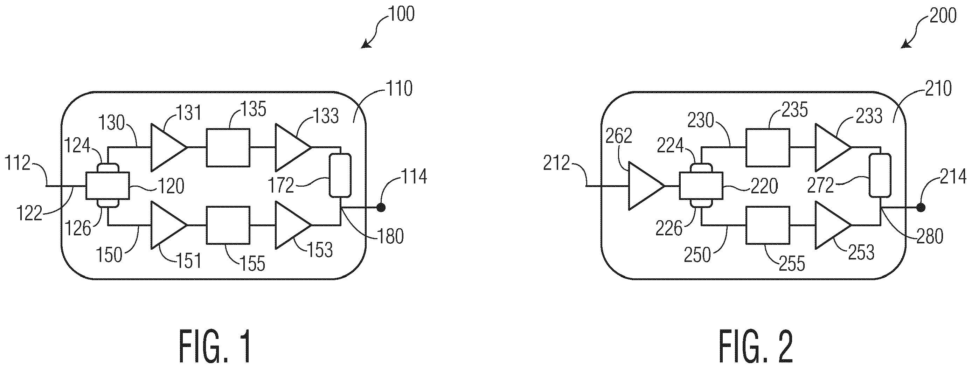

FIG. 1 is a simplified schematic diagram of Doherty power amplifier 100. As indicated in FIG. 1 with box 110, some or all components of Doherty power amplifier 100 may be implemented in a single device package or module (e.g., coupled to a single substrate).

Doherty power amplifier 100 includes an RF input node 112, an RF output node 114, a power splitter 120, a carrier amplifier path 130, a peaking amplifier path 150, a phase shift and impedance inverter line assembly 172, and a combining node 180 that is coupled to the RF output node 114.

When incorporated into a larger RF system, the RF input node 112 is coupled to an RF signal source (not illustrated), and the RF output node 114 is coupled to a load such as an antenna. The RF signal source provides an input RF signal, which is an analog signal that includes spectral energy that typically is centered around one or more carrier frequencies. Fundamentally, the Doherty power amplifier 100 is configured to amplify the input RF signal, and to produce an amplified RF signal at the RF output node 114.

Power splitter 120 has an input 122 and two outputs 124, 126. The power splitter input 122 is coupled to the RF input node 112 to receive the input RF signal. The power splitter 120 is configured to divide the RF input signal received at input 122 into first and second RF signals (or carrier and peaking signals), which are provided to the carrier and peaking amplifier paths 130, 150 through outputs 124, 126.

The outputs 124, 126 of the power splitter 120 are coupled to the carrier and peaking amplifier paths 130, 150, respectively. The carrier amplifier path 130 is configured to amplify the carrier signal from the power splitter 120. Similarly, the peaking amplifier path 150 is configured to amplify the peaking signal from the power splitter 120. In the non-inverted Doherty power amplifier shown in FIG. 1, the peaking signal output from the power splitter 120 lags the carrier signal by about 90 degrees. Paths 130, 150 are designed so that the amplified carrier and peaking signals arrive substantially in phase with each other at the combining node 180.

Carrier amplifier path 130 includes two power transistors coupled in series, where a first transistor functions as a driver amplifier 131 that has a relatively low gain, and a second transistor functions as a final-stage amplifier 133 that has a relatively high gain. In such an embodiment, a control terminal of the driver amplifier 131 transistor is electrically coupled to output 124 of power splitter 120. The output terminal of driver amplifier 131 is coupled to inter-stage matching network 135 which is, in turn, coupled to the control or input terminal of final-stage amplifier 133. Inter-stage matching network 135 is configured to provide an impedance match between the output terminal of driver amplifier 131 and the input terminal of final-stage amplifier 133.

The output terminal of final-stage amplifier 133 is coupled through a phase shift and impedance inverter line assembly 172 to the combining node 180. In a 90-0 Doherty power amplifier, the phase shift and impedance inverter line assembly 172 applies about a 90 degree phase shift to the amplified carrier signal to ensure that the amplified carrier and peaking signals arrive in phase at the combining node 180.

In a similar manner, peaking amplifier path 150 includes two power transistors coupled in series, where a first transistor functions as a driver amplifier 151 that has a relatively low gain, and a second transistor functions as a final-stage amplifier 153 that has a relatively high gain. In such an embodiment, an input or control terminal of the driver amplifier 151 transistor is electrically coupled to output 126 of power splitter 120. The output terminal of driver amplifier 151 is coupled to inter-stage matching network 155 which is, in turn, coupled to the input or control terminal of final-stage amplifier 153. Inter-stage matching network 155 is configured to provide an impedance match between the output terminal of driver amplifier 151 and the input terminal of final-stage amplifier 153.

The amplifier 100 is designed so that, during operation, carrier amplifier path 130 provides amplification for relatively low level input signals, and both amplification paths 130, 150 operate in combination to provide amplification for relatively high level input signals. This may be accomplished, for example, by biasing the final-stage amplifier 133 of carrier amplifier path 130 so that the final-stage amplifier 133 operates in a class AB mode, and biasing final-stage amplifier 153 of peaking amplifier path 150 so that final-stage amplifier 153 operates in a class C mode.

As illustrated in FIG. 1, the configuration of Doherty power amplifier 100 requires a separate driver amplifier (i.e., driver amplifier 131 and driver amplifier 151) for each amplifier path.

An alternative configuration may be implemented, however, in which a single driver amplifier is used to amplify the low-level RF signal received at the RF input terminal. The output of that single driver amplifier can then be split by a power splitter to generate two output signals that are supplied to carrier and peaking output amplifiers, respectively.

To illustrate, FIG. 2 depicts Doherty power amplifier 200 in which a single driver amplifier is used to amplify an RF input signal before the signal is split to supply two input signals to the amplifier's carrier and peaking paths. As indicated in FIG. 2 with box 210, some or all components of Doherty power amplifier 200 may be implemented in a single device package or module (e.g., coupled to a single substrate).

Doherty power amplifier 200 includes an RF input node 212, a driver amplifier 262, a power splitter 220, a carrier amplifier path 230, a peaking amplifier path 250, a phase shift and impedance inverter line assembly 272, and a combining node 280 that is coupled to RF output node 214.

When incorporated into a larger RF system, the RF input node 212 is coupled to an RF signal source (not illustrated), and the RF output node 214 is coupled to a load such as an antenna. The RF signal source provides an input RF signal, which is an analog signal that includes spectral energy that typically is centered around one or more carrier frequencies. Fundamentally, the Doherty power amplifier 200 is configured to amplify the input RF signal, and to produce an amplified RF signal at the RF output node 214.

Driver amplifier 262 is configured to receive the RF input signal from RF input node 212 at an input terminal (e.g., a control terminal) of driver amplifier 262. Driver amplifier 262 has a relatively low gain. The output of driver amplifier 262 is supplied to an input 222 of power splitter 220. Power splitter 220 is configured to divide the amplified RF input signal received at input 222 from driver amplifier 262 into first and second RF signals (or carrier and peaking signals), which are provided to the carrier and peaking amplifier paths 230, 250 through outputs 224, 226.

The outputs 224, 226 of the power splitter 220 are coupled to the carrier and peaking amplifier paths 230, 250, respectively.

The carrier amplifier path 230 is configured to amplify the carrier signal from the power splitter 220. Similarly, the peaking amplifier path 250 is configured to amplify the peaking signal from the power splitter 220. In the non-inverted Doherty power amplifier shown in FIG. 2, the peaking signal output from the power splitter 220 lags the carrier signal by about 90 degrees. Paths 230, 250 are designed so that the amplified carrier and peaking signals arrive substantially in phase with each other at the combining node 280.

Carrier amplifier path 230 includes inter-stage matching network 235 which is coupled between power splitter output 224 and an input terminal (e.g., a control terminal) of final-stage amplifier 233. Inter-stage matching network 235 is configured to provide an impedance match between the power splitter 220 and final-stage amplifier 233.

The output terminal of output amplifier 233 is coupled through a phase shift and impedance inverter line assembly 272 to the combining node 280. In a 90-0 Doherty power amplifier, the phase shift and impedance inverter line assembly 272 applies about a 90 degree phase shift to the amplified carrier signal to ensure that the amplified carrier and peaking signals arrive in phase at the combining node 280.

In a similar manner, peaking amplifier path 250 includes inter-stage matching network 255 which is coupled between power splitter output 226 and an input terminal (e.g., a control terminal) of final-stage amplifier 253. Inter-stage matching network 255 is configured to provide an impedance match between the power splitter 220 and final-stage amplifier 253.

The amplifier 200 is designed so that, during operation, driver amplifier 262 preamplifies the input RF signal, and both amplification paths 230, 250 operate in combination to provide amplification to the outputs of power splitter 220 to generate relatively high level output signals. This may be accomplished, for example, by biasing the final-stage amplifier 233 of carrier amplifier path 230 so that the final-stage amplifier 233 operates in a class AB mode, and biasing final-stage amplifier 253 of peaking amplifier path 250 so that final-stage amplifier 253 operates in a class C mode.

In the Doherty power amplifier configurations depicted in FIGS. 1 and 2, a significant amount of space within an amplifier module or device is occupied by the components that make up the inter-stage matching networks 135, 155, 235, 255. These networks are usually composed of a number of passive devices, such as resistors, capacitors, and inductors, that are provided by individual surface mount components, multiple integrated passive devices (IPDs), and/or chip components with component case size designations of 0201. These can take up a significant amount of the substrate surface on which the amplifier is formed.

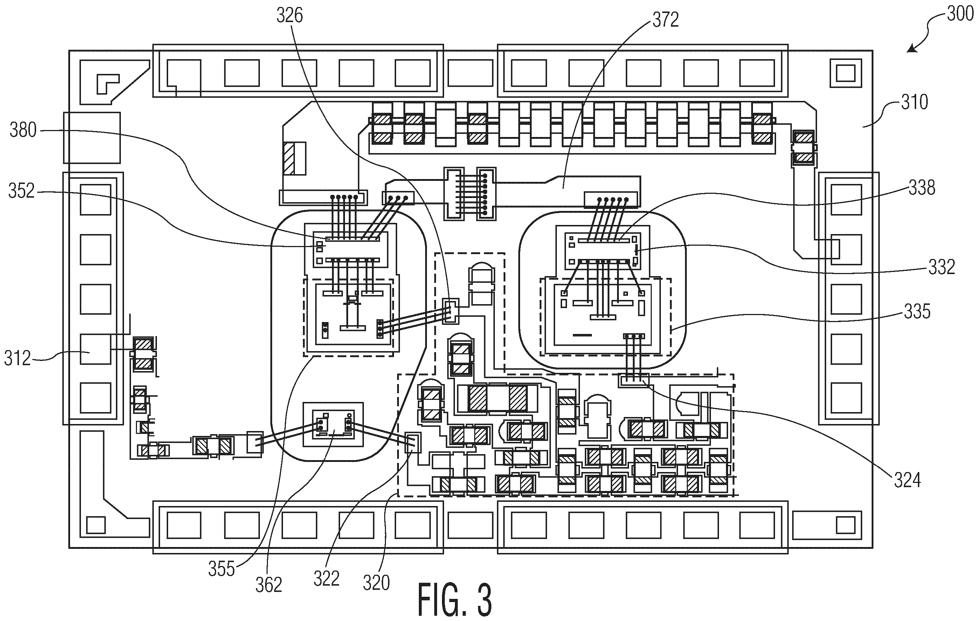

To illustrate, FIG. 3 is a top view of a Doherty power amplifier module 300 that includes a substrate 310, a single driver amplifier transistor 362, a power splitter 320 enclosed in a dashed box (e.g., power splitter 220, FIG. 2), a final-stage carrier amplifier transistor 332 (e.g., final-stage amplifier 233 of carrier amplifier path 230 of FIG. 2), a final-stage peaking amplifier transistor 352 (e.g., final-stage amplifier 253 of peaking amplifier path 250 of FIG. 2), a carrier-path inter-stage matching network 335 implemented using a first IPD (e.g., inter-stage matching network 235 of FIG. 2) and coupled between output 324 of power splitter 320 and final-stage carrier amplifier transistor 332, a peaking-path inter-stage matching network 355 implemented using a second IPD (e.g., inter-stage matching network 255 of FIG. 2) and coupled between output 326 of power splitter 320 and final-stage peaking amplifier transistor 352, a combining node 380 (e.g., combining node 280 of FIG. 2), a phase shift and impedance inverter line assembly 372 (e.g., phase shift and impedance inverter line assembly 272 of FIG. 2) coupled between the output of final-stage peaking amplifier transistor 352 and the combining node 380, and various other circuit elements.

Doherty power amplifier module 300 may be implemented as a land grid array (LGA) module, for example. Accordingly, the substrate 310 has a component mounting surface shown in FIG. 3 and an opposed terminal surface (not shown). The component mounting surface and the components mounted to that surface may be covered with an encapsulant material (e.g., a plastic encapsulant). In an alternate embodiment, the components could be contained within an air cavity, which is defined by various structures (not illustrated) overlying the mounting surface.

Substrate 310 of module 300 may be a multi-layer organic substrate (e.g., formed from PCB materials) with a plurality of metal layers which are separated by dielectric material. According to an embodiment, a bottom metal layer of substrate 310 can be utilized to provide externally accessible, conductive landing pads, which can enable surface mounting of the Doherty power amplifier module 300 onto a separate substrate (not illustrated) that provides electrical connectivity to other portions of an RF system.

One or more other metal layers of substrate 310 may be used to convey DC voltages (e.g., DC bias voltages) and to provide a ground reference. Other layers may be used to convey RF and other signals through module 300. Phase shift and impedance inverter line assembly 372 may be formed from portions of a patterned metal layer (or from portions of one or more other conductive layers). Conductive vias provide for electrical connectivity between the metal layers of substrate 310.

Each of the final-stage carrier and peaking amplifier transistors 332, 352 can be monolithic power transistor integrated circuits (ICs) that may produce significant amounts of heat during operation. In addition, each of the final-stage carrier and peaking amplifier transistors 332, 352 also need access to a ground reference. Accordingly, in an embodiment, substrate 310 also includes a plurality of electrically and thermally conductive coins or trenches to which the carrier and peaking amplifier transistors 332, 352 are coupled (e.g., with solder, brazing material, silver sinter, or other die attach materials). The coins or trenches can extend through the substrate 310 thickness to provide heat sinks and ground reference access to the carrier and peaking amplifier transistors 332, 352.

The driver amplifier transistor 362 has an input that is electrically coupled to the RF input terminal 312 (e.g., RF input node 212 of FIG. 2) to receive an input RF signal. The output of the driver amplifier transistor 362 is electrically coupled to the power splitter 320. As illustrated, power splitter 320 includes several discrete components that are electrically coupled together. Power splitter 320 includes an input 322 (e.g., input 222, FIG. 2) and two outputs 324, 326 (e.g., outputs 224, 226, FIG. 2). The input 322 is electrically coupled (e.g., through wirebonds, as shown) to the output of the driver amplifier transistor 362 . In addition, the outputs 324, 326 of power splitter 320 are electrically coupled input terminals of inter-stage matching network 335 and inter-stage matching network 355, respectively. Power splitter 320 is configured to split the power of the amplified input RF signal received from the driver amplifier die 362 into first and second RF signals (e.g., carrier and peaking signals), which are produced at outputs 324, 326 of power splitter 320. As discussed previously, in the depicted implementation of module 300, power splitter 320 consists of a relatively large number of fixed-value, passive components.

The first and second RF signals generated by power splitter 320 may have equal or unequal power, as discussed previously. The first RF signal produced at output 324 of power splitter 320 is conveyed through inter-stage matching network 335 and amplified by carrier amplifier transistor 332 along the carrier amplifier path.

In the carrier amplifier path, an amplified RF carrier signal is produced by the carrier amplifier transistor 332 at carrier output terminal 338. In an embodiment, the carrier output terminal 338 is electrically coupled to a first end of phase shift and impedance inverter assembly 372. A second end of the phase shift and impedance inverter assembly 372 is coupled to the combining node 380.

According to an embodiment, phase shift and impedance inverter assembly 372 is implemented with a transmission line (e.g., a microstrip line formed on a surface of substrate 310), and an electrical length of the entire assembly between the carrier output terminal 338 and combining node 380 is about lambda/4 ($\lambda/4$) (i.e., about 90 degrees).

Moving back to the power splitter 320, the second RF signal (i.e., the peaking signal) produced at output 326 of the power splitter 320 is conveyed through inter-stage matching network 355 to an input (e.g., a control terminal) of peaking amplifier transistor 352 (e.g., final-stage amplifier 253 of FIG. 2). Power splitter 320 may impart about a 90 degree phase shift to the RF signal provided at output 326. Accordingly, in that configuration, the phase of the peaking RF signal received by peaking amplifier transistor 352 is delayed by about 90 degrees with respect to the carrier signal received at carrier amplifier transistor 332.

Inter-stage matching network 335 is configured to provide proper impedance matching between the first power splitter output 324 and the input to carrier amplifier transistor 332. Similarly, inter-stage matching network 355 is configured to provide proper impedance matching between the second power splitter output 326 and the input to peaking amplifier transistor 352.

Besides the components described above, module 300 also includes additional bias circuitry (not shown) and/or bias circuitry connections configured to provide gate and drain bias voltages to some or all of the driver and final-stage amplifier transistors 362, 332, 352. The bias circuitry may include, among other things, a plurality of landing pads, contacts, and other conductive structures and circuitry. Bias voltages provided to the gates and/or drains of the transistors 362, 332, 352 facilitate Doherty operation of the module. For example, the carrier amplifier transistor 332 may be biased to operate in class AB mode, and the peaking amplifier transistor 352 may be biased to operate in class C mode. The above-described configuration corresponds to a non-inverted Doherty power amplifier.

As illustrated by FIG. 3, power splitter 320, carrier inter-stage matching network 335, and peaking inter-stage matching network 355 consume a significant portion of the surface area of substrate 310 of module 300.

In the present disclosure an alternative implementation of module 300 of FIG. 3 is present in which power splitter 320, carrier inter-stage matching network 335, and peaking inter-stage matching network 355 are replaced by a single circuit, which may be implemented on a single substrate and/or a single integrated passive device. Specifically, the components are replaced by a power splitter configured as a Wilkinson splitter that operates to provide both power splitter and impedance matching network functionality.

Some Doherty power amplifiers are implemented as asymmetric devices in which the size ratio of the peaking amplifier transistor to the carrier amplifier transistor may be about 2:1. In that configuration, an input impedance of the carrier amplifier may be approximately twice that of the peaking amplifier. Given these general ratios, the 2:1 asymmetric Doherty power amplifier configuration typically incorporates a power splitter that output signals of different powers. Specifically, a 2:1 asymmetric Doherty power amplifier may require a power splitter that outputs a first signal to the amplifier's carrier amplifier that is about half the power of the signal output to the amplifier's peaking amplifier. This splitter configuration can be realized in the form of a 2 decibel (dB)/5 dB power splitter or a 1.76 dB/4.76 dB splitter. In this arrangement, the peaking amplifier of the asymmetric Doherty power amplifier is driven about 3 dB harder than the carrier amplifier during operations.

In typical applications, asymmetric Doherty power amplifiers use a quadrature coupled splitter circuit, which can support asymmetry but is rigid in terms of impedance transformation and inherently provides a fixed 90 degree phase shift between outputs. When a particular Doherty power amplifier requires only 'about' 90 degrees, such a splitter, being fixed at exactly 90 degree phase shift, requires the additional of other phasing circuit components to operate optimally. Additionally, because conventional power splitters exhibit the same impedance at their respective output nodes, any asymmetric Doherty power amplifier that utilizes a conventional 2 dB/5 dB or 1.76 dB/4.76 dB power splitter requires additional inter-stage impedance matching networks (see, for example, inter-stage matching network 335 and inter-stage matching network 355 of FIG. 3) to ensure that the output impedance of the amplifier's driver amplifier is matched to the input impedance of the amplifier's final-stage carrier amplifier and final-stage peaking amplifier.

Embodiments of asymmetric Wilkinson splitters are therefore described herein, each of which is implemented as a power splitter with two output terminals in which the output signal power at one terminal is less in magnitude than the output signal power at the other output terminal. The required loading of the Wilkinson splitter for this topology inherently tracks the device that it is driving by virtue of the split ratio. Simple phase shift circuits on the outputs of the splitter may be used to create phase delays of about 90 degrees (or alternatively other phase delays, such as 60 degrees, 75 degrees, or other values) and simultaneously can provide further impedance transformation. Specifically, the magnitudes of the two output signals of the Wilkinson splitter at the power splitter outputs may have a power ratio of 2 dB/5 dB. In other embodiment, the magnitudes of the two output signals may have power ratios of 1:1.6 up to 1:2.2, but depending on the application, different power level ratios may be implemented by a given Wilkinson power splitter. Furthermore, in such a Wilkinson power splitter, the ratio between impedances at the splitter's outputs may be such that the output impedance of the first power splitter output at which the lesser magnitude output signal is generated, may be about twice that of the output impedance of the second power splitter output at which the greater magnitude output signal is generated.

As such, not only are the power magnitudes of the carrier and peaking signals output by the Wilkinson power splitter asymmetric, but the splitter's output impedances are also asymmetric. The asymmetry of these electrical characteristics of the outputs for the Wilkinson power splitter, as described herein, enable that specific power splitter configuration to replace the power splitter and inter-stage matching network components of a conventional symmetric or asymmetric Doherty power amplifier.

Specifically, by carefully selecting the output impedances of the two outputs of a particular implementation of the Wilkinson power splitter, such as by setting the output impedance of the first (carrier-amplifier-coupled) splitter output at 30 ohms, or in a range from 25 ohms to 35 ohms, and the output impedance of the second (peaking-amplifier-coupled) splitter output at 15 ohms, or in a range from 10 ohms to 20 ohms., the output impedances of the Wilkinson power splitter can be set to match the input impedances of the final-stage power transistors (e.g., GaN transistor devices) implementing the carrier and peaking amplifiers of the Doherty power amplifier. In conjunction with the phase adjustments provided by the output phase networks and the bandwidth enhancing input transformation afforded by the Wilkinson splitter, the various interface impedances of the Wilkinson splitter can be optimized. A benefit of the Wilkinson splitter configuration is that these optimizations (i.e., output transformation, bandwidth enhancing input transformation, and matching input/output impedance) tend to be optimized together (i.e., a change to one factor, positively influences the other factors) and, as such, a Wilkinson splitter configured for use in an asymmetric Doherty power amplifier can be constructed with relatively few simple components. This configuration, as detailed below, can therefore greatly reduce the complexity (or even the need for) inter-stage matching networks within a Doherty power amplifier.

In the present Doherty power amplifier design, therefore, it is possible to provide proper impedance matching at the outputs of the asymmetric Wilkinson splitter, thus enabling the outputs of the splitter to be coupled directly to the input terminals of the final-stage carrier and peaking power transistors with no intervening inter-stage impedance matching networks. Specifically, in embodiments of the present Doherty power amplifier design, embodiments of the Wilkinson power splitter provide the functionality of a power splitter while also "pre-matching" the driver amplifier by raising the impedance level of the input splitter closer to the optimal output impedance of the class AB driver impedance. For example, rather than a typical 50 ohm input to a conventional Wilkinson splitter, embodiments of the proposed integrated Wilkinson splitter may have a significantly higher (e.g., 100 ohm or other value) input impedance.

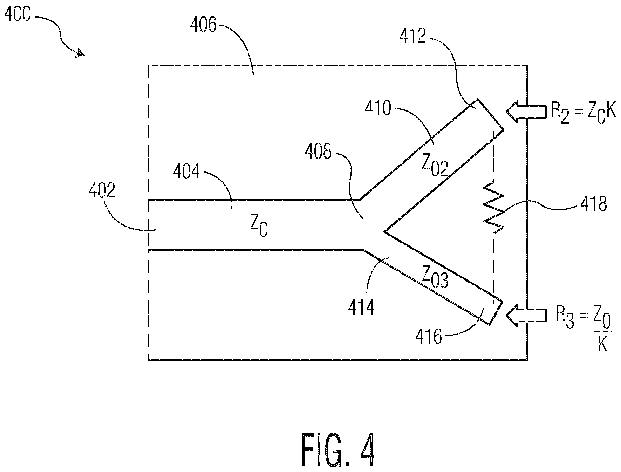

FIG. 4 is a diagram illustrating a conceptual design of an embodiment of a Wilkinson power splitter implemented as a combination of microstrip transmission lines on a substrate 406. In other embodiments, however, it will be apparent that splitter 400 may be implemented using a number of lumped element equivalents as opposed to microstrip transmission lines and to facilitate device integration. Splitter 400 includes an input terminal 402 coupled to a first end of a first transmission line 404. First transmission line 404 extends from input terminal 402 to branch point 408 along a surface of substrate 406. A second transmission line 410 extends over a surface of substrate 406 from branch point 408 to output terminal 412. In a similar manner, a third transmission line 414 extends over a surface of substrate 406 from branch point 408 to output terminal 416. An impedance of first transmission line 404 is designated $Z_0$, an impedance of second transmission line 410 is designated $Z_{02}$, and an impedance of third transmission line 414 is designated $Z_{03}$. A resistance 418 is coupled between output terminal 412 and output terminal 416.

In the present asymmetric Wilkinson power splitter embodiments, given a particular input signal received at input terminal 402, splitter 400 is configured such that the power, $P_2$, of a resulting carrier output signal at output terminal 412 is different than the power, $P_3$, of a resulting peaking output signal at output terminal 416. To define the relationship of the power levels of those output signals, a constant K can be defined for splitter 400, per the expression $K^2 = \frac{P_3}{P_2}$.

By selecting the value of K to achieve a desired relationship between the power levels of the signals output at terminals 412 and 416, it is possible to determine the desired output impedances of transmission lines 404, 410, and 414. Specifically, for a given impedance of first transmission line 404, the output impedances of second transmission line 410 and third transmission line 414 for a particular value of K is given by the following expressions:

$$Z_{03} = Z_0 \sqrt{\frac{1+K^2}{K^3}} \tag{1}$$

$$Z_{02} = K^2 * Z_{03} \tag{2}$$

Furthermore, the resistance value of resistance 418 is given as:

$$R = Z_0 \left(K + \frac{1}{K}\right) \tag{3}$$

Given these criteria, an embodiment of an optimized Wilkinson splitter 400 can be designed for implementation as a combined power splitter and impedance matching network for use in an asymmetric Doherty power amplifier. In asymmetric Doherty power amplifiers, the size ratio (e.g., the volume ratio) between the final-stage peaking amplifier transistor die and final-stage carrier amplifier transistor die is typically 2:1, though in various asymmetric Doherty amplifier configurations the ratio may have other values, such as by being in the range from 1.6:1 to 2.2:1) such that the signal power level ratio between outputs of the signal splitter are desired to have the same power ratio (typically around 2 dB for the carrier signal being output by the splitter to the amplifier's carrier amplifier and around 5 dB for the peaking signal being output by the splitter to the amplifier's peaking amplifier). Similarly, the output impedance ratios for the output terminals of the power splitter should have the same 2:1 ratio. In a conventional power splitter, this requires the incorporation of additional matching networks to transform the output impedances of the conventional power splitter's output terminals to the impedances at the inputs of the peaking and carrier amplifiers. However, in the embodiment of Wilkinson splitter 400, when the splitter 400 is configured to achieved the desired asymmetric power level outputs, the output impedances of the output terminals 412 and 416 of splitter 400 inherently have that same 2:1 relationship.

In short, for splitter 400, when the power of the carrier output signal, $P_2$, is equal to $2*P_3$, the output impedance $Z_{02}$ at output terminal 412 is also about $2*Z_{03}$. Consequently, a properly configured splitter 400 utilized in an asymmetric Doherty power amplifier where the size ratio of peaking amplifier transistor to carrier amplifier transistor is about 2:1 can simultaneously perform the functions of both a power splitter and inter-stage impedance matching networks.

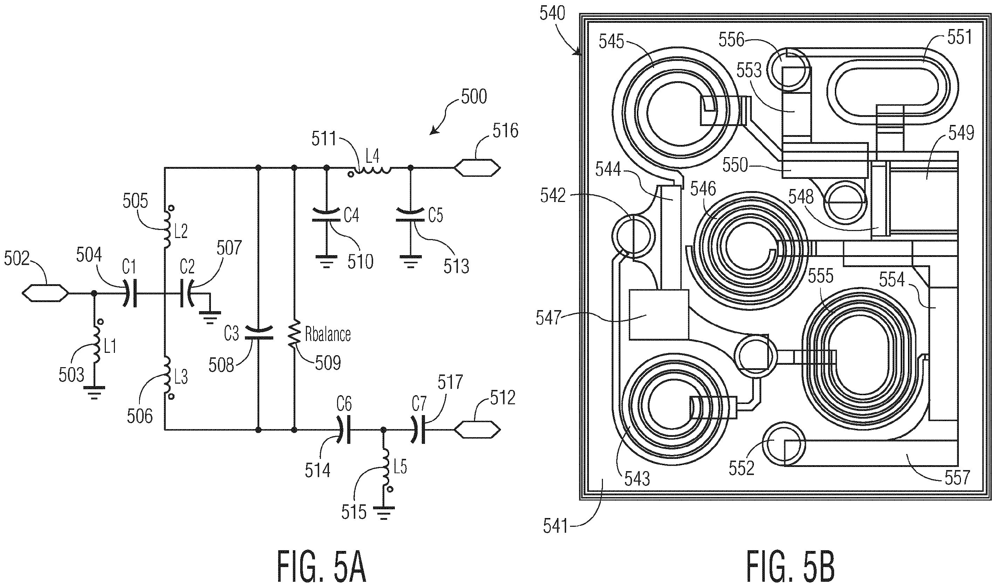

To illustrate, FIG. 5A is a circuit diagram depicting an implementation of Wilkinson power splitter 500 configured to for use in an asymmetric Doherty power amplifier. FIG. 5B depicts an example IPD layout for the device of FIG. 5B. The IPD 540 of FIG. 5B includes a substrate 541 over which components of the device can be formed. Typically, substrate 541 includes a substrate material like a printed circuited board (PCB) that allows the conductive components of IPD 540 to be formed by plating or other deposition process as micro strip transmission lines.

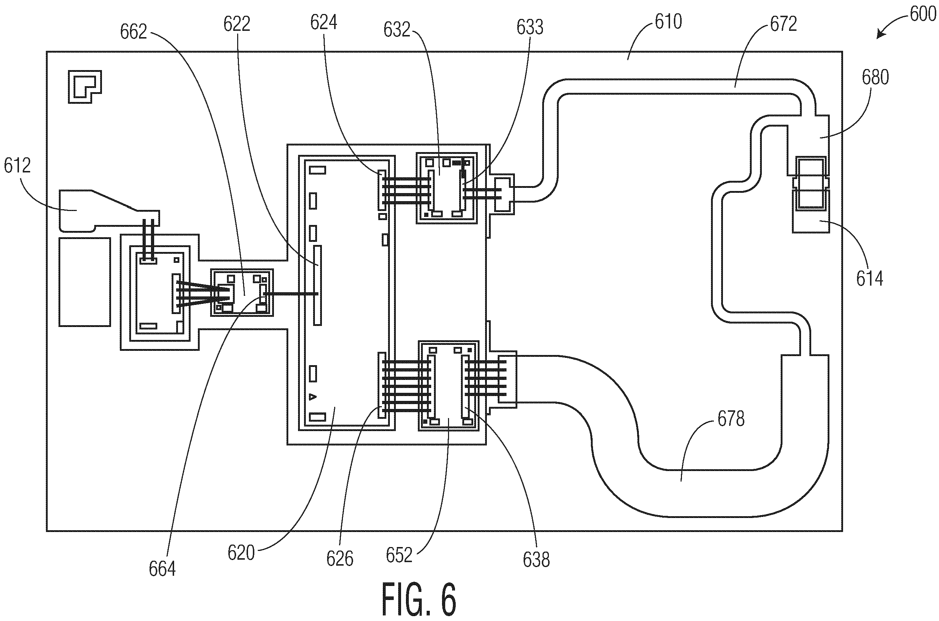

Wilkinson power splitter 500 includes an RF input terminal 502 (e.g., input terminal 402 of FIG. 4 or terminal 542 of FIG. 5B), a first output terminal 512 (e.g., output terminal 412 of FIG. 4 or terminal 552, FIG. 5B), and a second output terminal 516 (e.g., output terminal 416 of FIG. 4 or terminal 556, FIG. 5B). Input terminal 502 is coupled to an input impedance matching circuit that includes inductor 503 (e.g., spiral inductor 543 of FIG. 5B) and series-coupled capacitor 504 (e.g., capacitor 544 of FIG. 5B). Inductor 503 has a first terminal coupled to input terminal 502 and a second terminal coupled to a ground node. Capacitor 504 has a first terminal coupled to input terminal 502. The input impedance matching circuit that includes inductor 503 and capacitor 504 can be configured to match the input impedance of Wilkinson power splitter 500 to the output of a driver amplifier (e.g., driver amplifier 662, FIG. 6), for example. In typical applications, where a Doherty amplifier is configured to amplify RF input signals having frequencies around 3.5 gigahertz (GHz), inductor 503 may have an inductance in the range of 1 to 3 nanoHenries (nH) and capacitor 504 may have a capacitance in the range of 1 picoFarad (pF) to 2 pF, though in various applications/embodiments, other component values may be used.

The second terminal of capacitor 504 is coupled, in turn, to two parallel legs of the Wilkinson power splitter 500, where a first leg includes inductor 506 (e.g., spiral inductor 546 of FIG. 5B), and a second leg includes inductor 505 (e.g., spiral inductor 545 of FIG. 5B). More specifically, the second terminal of capacitor 504 is coupled to first terminals of inductors 505 and 506. In typical applications, where a Doherty amplifier is configured to amplify RF input signals having frequencies around 3.5 GHz, the inductance values of inductors 505 and 506 may range from 0.5 nH to 2 nH, though in various applications/embodiments, other component values may be used.

The second terminal of capacitor 504 is also coupled to a first terminal of capacitor 507 (e.g., capacitor 547 of FIG. 5B). A second terminal of capacitor 507 is coupled to ground such that capacitor 507 operates as a lumped element equivalent for one of the two quarter wavelength lines that create the Wilkinson structure in conjunction with inductors 505 and 506. The individual capacitive contributions from each line are absorbed into a single capacitor.

Capacitor 508 (e.g., capacitor 548 of FIG. 5B) and balance resistor 509 (e.g., resistor 549 of FIG. 5B) are coupled in parallel between the two legs of the Wilkinson power splitter 500. Capacitor 508 (in conjunction with capacitor 507) operates as a lumped element equivalent for one of the two quarter wavelength lines that create the Wilkinson structure in conjunction with inductors 505 and 506. The individual capacitive contributions from each line are absorbed into a single capacitor. Resistor 509 is configured to enable isolation between outputs 516 and 512 by providing an equal amplitude signal 180 degrees out of phase from a reflected signal originating at the opposing port. It is nominally twice the value of the characteristic impedance chosen for the Wilkinson splitter. Capacitor 508 and resistor 509 are coupled between the second terminals of inductor 505 and inductor 506.

A variable phase advance and impedance transformer along the first leg of splitter 500, which includes capacitor 514 (e.g., capacitor 554 of FIG. 5B), inductor 515 (e.g., spiral inductor 555 of FIG. 5B), and capacitor 517 (e.g., capacitor 557 of FIG. 5B), is coupled to the second terminal of inductor 506. Specifically, capacitor 514 has a first terminal coupled to the second terminal of inductor 506, and a second terminal coupled to a first terminal of capacitor 517. Inductor 515 has a first terminal coupled to the first terminal of capacitor 517, and a second terminal coupled to a ground node. A second terminal of capacitor 517 is coupled to carrier output terminal 512 (e.g., output 552, FIG. 5B).

A variable phase lag circuit along the second leg of splitter 500, which includes capacitor 510 (e.g., capacitor 550 of FIG. 5B), inductor 511 (e.g., spiral inductor 551 of FIG. 5B), and capacitor 513 (e.g., capacitor 553 of FIG. 5B), is also coupled to the second terminal of inductor 505. Specifically, capacitor 510 has a first terminal coupled to the second terminal of inductor 505 and a second terminal coupled to a ground node. A first terminal of inductor 511 is coupled to the second terminal of inductor 505 and a second terminal of inductor 511 is coupled to output terminal 516 (e.g., output terminal 556 of FIG. 5B). Capacitor 513 has a first terminal coupled to the second terminal of inductor 511, and a second terminal coupled to a ground node. The first terminal of capacitor 513 also is coupled to peaking output terminal 516 (e.g., output 556, FIG. 5B).

It may be noted here that the circuit topology for the variable phase advance and impedance transformer along the first leg of splitter 500 is different from the circuit topology for the variable phase lag circuit along the second leg of splitter 500. More specifically, whereas the circuit topology for the variable phase advance and impedance transformer along the first leg of splitter 500 includes two series capacitors 514, 517 and a shunt inductor 515 (e.g., corresponding to a high pass circuit), the circuit topology for the variable phase lag circuit along the second leg of splitter 500 includes two shunt capacitors 510, 513 and a series inductor 511 (e.g., corresponding to a low pass circuit). The effect of these different circuit topologies is that the output impedances at the first and second outputs 512, 516 are different. This has the advantage of allowing the different output impedances to be matched to the inputs of the carrier and peaking transistors (e.g., transistors 632, 652, FIG. 6), thus facilitating direct connection between the power splitter outputs 512, 516 and the carrier and peaking transistor inputs.

For Doherty amplifiers operating at around 3.5 GHz, capacitance values of the capacitors (e.g., capacitors 510, 513, 514, 517) in the phase shifting networks will range from around 0.5 pF to 10 pF and inductance values (e.g., for inductors 511, 515) will range from around 0.5 nH to 3 nH. The lower port impedances inherent to this application results in lower inductance values making them easier to realize.

In this configuration, RF input terminal 502 of Wilkinson power splitter 500 is configured to receive an input RF signal (e.g., the signal output by a driver amplifier of a Doherty power amplifier), to divide the power of the input RF signal into first and second output signals (e.g., carrier and peaking signals), and to provide the first and second output signals at the first and second output terminals 512, 516. The output terminal 512 is configured to connect directly to an input terminal of a carrier amplifier output terminal 516 is configured to connect directly to an input terminal of a peaking amplifier in an asymmetrical Doherty power amplifier.

Within Wilkinson power splitter 500, the input signal to the Doherty power amplifier is split into two independent signals that are output at output terminals 512 and 516, where a magnitude of the signal output at output terminal 516 is about twice that of the signal output at output terminal 512.

In the configuration shown in FIGS. 5A and 5B, Wilkinson power splitter 500 operates as a power splitter circuit that can achieve isolation between output terminals 512 and 516 while maintaining a matched condition across all terminals (i.e., input terminal 502, output terminal 516, and output terminal 516). Although the inductor components of Wilkinson power splitter 500 depicted in FIG. 5B are shown as being implemented by spiral inductor structures, it should be understood that the inductive components of Wilkinson power splitter 500 may be implemented using other forms of inductive transmission lines (e.g., coaxial cable) or lumped circuit elements (e.g., inductors and capacitors).

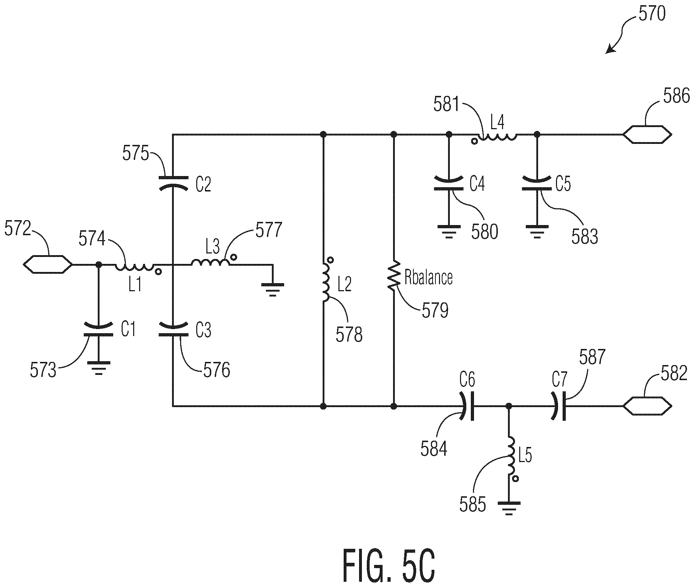

FIG. 5C is a circuit diagram depicting an alternate implementation of a Wilkinson power splitter 570 configured for use in an asymmetric Doherty power amplifier. In the same manner as Wilkinson power splitter 500, the components of Wilkinson power splitter 570 could be implemented within an IPD for incorporation into a larger asymmetric Doherty power amplifier device.

Wilkinson power splitter 570 includes an RF input terminal 572 (e.g., input terminal 402, FIG. 4), a first output terminal 582 (e.g., output terminal 412, FIG. 4), and a second output terminal 586 (e.g., output terminal 416, FIG. 4). Input terminal 572 is coupled to an input impedance matching circuit that includes capacitor 573 and series-coupled inductor 574. Capacitor 573 has a first terminal coupled to input terminal 572 and a second terminal coupled to a ground node. Inductor 574 has a first terminal coupled to input terminal 572. The input impedance matching circuit that includes capacitor 573 and inductor 574 can be configured to match the input impedance of Wilkinson power splitter 570 to the output of a driver amplifier (e.g., driver amplifier 662, FIG. 6). In typical applications, where a Doherty amplifier is configured to amplify RF input signals having frequencies around 3.5 gigahertz (GHz), inductor 574 may have an inductance in the range of 1 to 3 nanoHenries (nH) and capacitor 504 may have a capacitance in the range of 0.5 picoFarad (pF) to 2 pF, though in various applications/embodiments, other component values may be used.

The second terminal of inductor 574 is coupled, in turn, to the two parallel legs of the Wilkinson power splitter, where a first leg includes capacitor 576, and a second leg includes capacitor 575. More specifically, the second terminal of inductor 574 is coupled to first terminals of capacitors 575 and 576. The second terminal of inductor 574 is also coupled to a first terminal of inductor 577. A second terminal of inductor 577 is coupled to a ground node.

Inductor 578 and balance resistor 579 are coupled in parallel between the two legs of the Wilkinson power splitter 570. Specifically, inductor 578 and resistor 579 are coupled between the second terminals of capacitor 575 and capacitor 576. In this configuration, capacitors 575, 576 and inductors 577 and 578 form the complimentary high-pass lumped element implementation of the 1/4 wavelength transmission lines depicted in figure Fig. 5A. The individual inductive contributions from each line are absorbed into a single inductor. Balance resistor 579 operates in the Wilkinson configuration to isolate the output ports of Wilkinson power splitter 500.

A variable phase advance and impedance transformer along the first leg of splitter 570, which includes capacitor 584, inductor 585, and capacitor 587, is coupled to the second terminal of capacitor 576. Specifically, capacitor 584 has a first terminal coupled to the second terminal of capacitor 576, and a second terminal coupled to a first terminal of capacitor 587. Inductor 585 has a first terminal coupled to the first terminal of capacitor 587, and a second terminal coupled to a ground node. A second terminal of capacitor 587 is coupled to carrier output terminal 582.

A variable phase lag circuit along the second leg of splitter 570, which includes capacitor 580, inductor 581, and capacitor 583, is also coupled to the second terminal of capacitor 575. Specifically, capacitor 580 has a first terminal coupled to the second terminal of capacitor 575 and a second terminal coupled to a ground node. A first terminal of inductor 581 is coupled to the second terminal of capacitor 575 and a second terminal of inductor 581 is coupled to capacitor 583. Capacitor 583 has a first terminal coupled to the second terminal of inductor 581, and a second terminal coupled to a ground node. The first terminal of capacitor 583 also is coupled to peaking output terminal 586.

Again, it may be noted here that the circuit topology for the variable phase advance and impedance transformer along the first leg of splitter 570 is different from the circuit topology for the variable phase lag circuit along the second leg of splitter 570. More specifically, whereas the circuit topology for the variable phase advance and impedance transformer along the first leg of splitter 570 includes two series capacitors 584, 587 and a shunt inductor 585 (e.g., corresponding to a high pass circuit), the circuit topology for the variable phase lag circuit along the second leg of splitter 570 includes two shunt capacitors 580, 583 and a series inductor 581 (e.g., corresponding to a low pass circuit). The effect of these different circuit topologies is that the output impedances at the first and second outputs 582, 586 are different. This has the advantage of allowing the different output impedances to be matched to the inputs of the carrier and peaking transistors (e.g., transistors 632, 652, FIG. 6), thus facilitating direct connection between the power splitter outputs 582, 586 and the carrier and peaking transistor inputs.

In this configuration, RF input terminal 572 of Wilkinson power splitter 570 is configured to receive an input RF signal (e.g., the signal output by a driver amplifier of an asymmetrical Doherty power amplifier), to divide the power of the input RF signal into first and second output signals (e.g., carrier and peaking signals), and to provide the first and second output signals at the first and second output terminals 582, 586. The output terminal 582 is configured to connect to an input terminal of a carrier amplifier in an asymmetric Doherty power amplifier, and the output terminal 586 is configured to connect to an input terminal of a peaking amplifier in the asymmetric Doherty power amplifier.

Within Wilkinson power splitter 570, the input signal is split into two independent signals that are output at output terminals 582 and 586, where a magnitude of the signal output at output terminal 582 is about twice that of the signal output at output terminal 586.

In the configuration shown in FIG. 5C, Wilkinson power splitter 570 operates as a power splitter circuit that can achieve isolation between output terminals 582 and 586 while maintaining a matched condition across all terminals (i.e., input terminal 572, output terminal 582, and output terminal 586).

FIG. 6 is a top view of a Doherty power amplifier module 600 incorporating IPD 540 of FIG. 5B. Doherty power amplifier module 600 includes substrate 610, RF input terminal 612, a single driver amplifier 662, Wilkinson power splitter 620 (e.g., as implemented by IPD 540 of FIG. 5B), final-stage carrier amplifier transistor die 632, final-stage peaking amplifier transistor die 652, carrier-path phase shift and impedance inversion element 672, peaking path phase shift element 678, combining node 680, RF output terminal 614, and various other circuit elements.

Doherty power amplifier module 600 may be implemented as an LGA module, for example. Accordingly, the substrate 610 has a component mounting surface. The component mounting surface and the components mounted to that surface of substrate 610 may be covered with an encapsulant material (e.g., a plastic encapsulant). In an alternate embodiment, the components could be contained within an air cavity, which is defined by various structures (not illustrated) overlying the mounting surface.

Substrate 610 of module 600 may be a multi-layer organic substrate (e.g., formed from PCB materials) with a plurality of metal layers which are separated by dielectric material. According to an embodiment, a bottom metal layer can be utilized to provide externally accessible, conductive landing pads, which can enable surface mounting of the Doherty power amplifier module 600 onto a separate substrate (not illustrated) that provides electrical connectivity to other portions of an RF system.

One or more other metal layers of the substrate 610 may be used to convey DC voltages (e.g., DC bias voltages) and to provide a ground reference. Other layers may be used to convey RF and other signals through module 600. Phase shift and impedance inversion elements 672, 678 may be formed from portions of a patterned metal layer (or from portions of one or more other conductive layers). Conductive vias provide for electrical connectivity between the metal layers of substrate 610.

Each of the carrier and peaking amplifier transistor die 632, 652 can be monolithic power transistor ICs that may produce significant amounts of heat during operation. In addition, each of the carrier and peaking amplifier transistor die 632, 652 also need access to a ground reference. Accordingly, in an embodiment, substrate 610 also includes a plurality of electrically and thermally conductive coins or trenches to which the carrier and peaking amplifier die 632, 652 are coupled (e.g., with solder, brazing material, silver sinter, or other die attach materials). The coins or trenches can extend through the substrate 610 thickness to provide heat sinks and ground reference access to the carrier and peaking amplifiers 632, 652.

As illustrated, Wilkinson power splitter 620 is implemented within a single device (i.e., by IPD 540 of FIG. 5B). Wilkinson power splitter 620 includes an input terminal 622 (e.g., input terminal 502 of FIG. 5A or terminal 542 of FIG. 5B) and two output terminals 624, 626 (e.g., output terminals 512, 516 of FIG. 5A or output terminals 552, 556 of FIG. 5B). Input terminal 622 is electrically coupled (e.g., through wirebonds, as shown) to output terminal 664 of driver amplifier 662 to receive an input RF signal that has been amplified by single driver amplifier 662. In addition, the output terminals 624, 626 of splitter 620 are electrically coupled to input terminals of amplifier die 632 and amplifier die 652, respectively. Wilkinson power splitter 620 is configured to split the power of the RF signal received from single driver amplifier 662 into first and second RF signals (e.g., carrier and peaking signals) based on the input signal received at input terminal 622, which are produced at output terminals 624, 626. Given the impedance matching and power output characteristics, as illustrated in FIG. 6, output terminal 624 can be directly coupled (e.g., with only a conductive connection and no intervening components or inter-stage matching networks) to the input terminal of amplifier die 632. Similarly, output terminal 626 can be directly coupled (e.g., with only a conductive connection and no intervening components or inter-stage matching networks) to the input terminal of amplifier die 652.

The first and second RF signals may have unequal power, as discussed previously. The first RF signal produced at output terminal 624 of Wilkinson power splitter 620 is conveyed to amplifier die 632 and is amplified through a carrier amplifier path. Specifically, an amplified RF signal is produced by amplifier die 632 at RF output terminal 633. In an embodiment, RF output terminal 633 is electrically coupled to a first end of phase shift and impedance inversion element 672.

According to an embodiment, phase shift and impedance inversion element 672 is implemented with a transmission line (e.g., a microstrip line) having an electrical length of about lambda/4 ($\lambda$/4) or less.

Moving back to Wilkinson power splitter 620, the second RF signal (i.e., the peaking signal) produced at output terminal 626 of Wilkinson power splitter 620 is conveyed to an input (e.g., a control terminal) of peaking amplifier die 652. As mentioned above, the output impedances of output terminals 624, 626 of Wilkinson power splitter 620 exhibit different output impedances enabling, in some embodiments, the output terminals 624, 626 to be coupled directly to input terminals of amplified die 632, 652.

Amplifier die 652 is configured to output an amplified version of the second RF signal which is output into RF output terminal 638 of Doherty power amplifier module 600.

Besides the components described above, module 600 also includes additional bias circuitry and/or bias circuitry connections configured to provide gate and drain bias voltages to some or all of the driver and output amplifiers, 662, 632, 652. The bias circuitry may include, among other things, a plurality of landing pads, contacts, and other conductive structures and circuitry. Bias voltages provided to the gates and/or drains of the transistors 662, 632, 652 facilitate Doherty operation of the module. For example, the transistors of carrier amplifier die 632 may be biased to operate in class AB mode, and the transistors of the peaking amplifier die 652 may be biased to operate in class C mode. In alternate embodiments, modifications could be made to configure the module 600 to function as an inverted or non-inverted Doherty power amplifier.

As compared to module 300 of FIG. 3, as illustrated by FIG. 6, by avoiding the need for additional separate inter-stage matching networks (i.e., inter-stage matching network 335 and inter-stage matching network 355 of FIG. 3) and instead providing an asymmetric Wilkinson power splitter 620 with different output impedances at output terminals 624, 626, as described above, a significant reduction in the size of components required to implement Doherty power amplifier module 600 can be achieved. In some implementations, this approach can reduce the overall size of a Doherty module by almost 1/3 as compared to conventional modules that utilize separate power splitters and inter-stage matching networks, creating significant potential cost and size reductions.

In some aspects, the techniques described herein relate to a Doherty power amplifier, including: a power splitter including a power splitter input terminal, a first power splitter output terminal having a first output impedance, and a second power splitter output terminal having a second output impedance that is different from the first output impedance, wherein the power splitter is an asymmetric Wilkinson power splitter configured to receive a first amplified signal at the power splitter input terminal, split the first amplified signal into a carrier signal and a peaking signal, output the carrier signal at the first power splitter output terminal, and output the peaking signal at the second power splitter output terminal; a carrier amplifier die including a carrier amplifier input terminal and a carrier amplifier output terminal, wherein the carrier amplifier input terminal is electrically coupled to the first power splitter output terminal, and the carrier amplifier die is configured to receive the carrier signal at the carrier amplifier input terminal and generate an amplified carrier signal based on the carrier signal at the carrier amplifier output terminal; a peaking amplifier die including a peaking amplifier input terminal and a peaking amplifier output terminal, wherein the peaking amplifier input terminal is electrically coupled to the second power splitter output terminal, and the peaking amplifier die is configured to receive the peaking signal at the peaking amplifier input terminal and generate an amplified peaking signal based on the peaking signal at the peaking amplifier output terminal; and a combining node electrically coupled to the carrier amplifier output terminal and the peaking amplifier output terminal, wherein the combining node is configured to receive and combine the amplified carrier signal and the amplified peaking signal to produce an amplified output radio frequency signal.

In some aspects, the techniques described herein relate to a Doherty power amplifier, wherein a power level of the peaking signal is greater than a power level of the carrier signal.

In some aspects, the techniques described herein relate to a Doherty power amplifier, wherein the power level of the peaking signal is from 1.6 to 2.2 times greater than the power level of the carrier signal and a volume of the peaking amplifier die is at least 1.6 times greater than a volume of the carrier amplifier die.

In some aspects, the techniques described herein relate to a Doherty power amplifier, wherein the first output impedance is greater than the second output impedance.

In some aspects, the techniques described herein relate to a Doherty power amplifier, wherein the output impedance of the first power splitter output terminal is between 25 ohms and 35 ohms and the output impedance of the second power splitter output terminal is between 10 ohms and 20 ohms.

In some aspects, the techniques described herein relate to a Doherty power amplifier, wherein the first power splitter output terminal is directly electrically coupled to the carrier amplifier input terminal.

In some aspects, the techniques described herein relate to a Doherty power amplifier, wherein the second power splitter output terminal is directly electrically coupled to the peaking amplifier input terminal.

In some aspects, the techniques described herein relate to a Doherty power amplifier, wherein the power splitter includes a first leg between the power splitter input terminal and the first power splitter output terminal, and a second leg between the power splitter input terminal and the second power splitter output terminal, wherein the first leg includes a first inductor and the second leg include a second inductor, and further including a balance resistor coupled between a terminal of the first inductor and a terminal of the second inductor, wherein the balance resistor is configured to provide isolation between the first power splitter output terminal and the second power splitter output terminal.

In some aspects, the techniques described herein relate to a Doherty power amplifier, wherein the first leg includes a variable phase advance circuit coupled between the terminal of the first inductor and the first power splitter output terminal.

In some aspects, the techniques described herein relate to a Doherty power amplifier, wherein the second leg includes a variable phase lag circuit coupled between the terminal of the second inductor and the second power splitter output terminal, wherein the variable phase advance circuit is configured differently from the variable phase lag circuit..

In some aspects, the techniques described herein relate to a Doherty power amplifier, further including: an input terminal configured to receive an input radio frequency signal; and a driver amplifier including a driver input terminal and a driver output terminal, wherein the driver amplifier is configured to receive the input radio frequency signal at the driver input terminal and output the first amplified signal at the driver output terminal.

In some aspects, the techniques described herein relate to a Doherty power amplifier, including: an input terminal configured to receive an input radio frequency signal; a driver amplifier including a driver input terminal and a driver output terminal, wherein the driver amplifier is configured to receive an input radio frequency signal at the driver input terminal and output a first amplified signal at the driver output terminal; a power splitter including a power splitter input terminal, a first power splitter output terminal having a first output impedance, and a second power splitter output terminal having a second output impedance that is different from the first output impedance, wherein the power splitter is an asymmetric Wilkinson power splitter; a carrier amplifier die including a carrier amplifier input terminal electrically coupled to the first power splitter output terminal; and a peaking amplifier die including a peaking amplifier input terminal electrically coupled to the second power splitter output terminal.

In some aspects, the techniques described herein relate to a Doherty power amplifier, wherein the output impedance of the first power splitter output terminal is between 25 ohms and 35 ohms and the output impedance of the second power splitter output terminal is between 10 ohms and 20 ohms.

In some aspects, the techniques described herein relate to a Doherty power amplifier, wherein a volume of the peaking carrier amplifier die is at least 1.6 times greater than a volume of the carrier amplifier die.

In some aspects, the techniques described herein relate to an integrated passive device, including: a substrate; and a power splitter on the substrate, the power splitter including a power splitter input terminal, a first power splitter output terminal having a first output impedance, and a second power splitter output terminal having a second output impedance that is different from the first output impedance, wherein the power splitter is an asymmetric Wilkinson power splitter configured to receive a first signal at the power splitter input terminal, divide the first signal into a first output signal and a second output signal, output the first output signal at the first power splitter output terminal, and output the second output signal at the second power splitter output terminal.

In some aspects, the techniques described herein relate to an integrated passive device, wherein a power level of the second output signal is greater than a power level of the first output signal.

In some aspects, the techniques described herein relate to an integrated passive device, wherein the power level of the second output signal is from 1.6 to 2.2 times greater than the power level of the first output signal.

In some aspects, the techniques described herein relate to an integrated passive device, wherein the power splitter includes a first leg between the power splitter input terminal and the first power splitter output terminal, and a second leg between the power splitter input terminal and the second power splitter output terminal, wherein the first leg includes a first spiral inductor on the substrate and the second leg includes a second spiral inductor on the substrate, and further including a balance resistor coupled between a terminal of the first spiral inductor and a terminal of the second spiral inductor.

In some aspects, the techniques described herein relate to an integrated passive device, wherein the first leg includes a variable phase advance circuit on the substrate coupled between the terminal of the first inductor and the first power splitter output terminal.

In some aspects, the techniques described herein relate to an integrated passive device, wherein the second leg includes a variable phase lag circuit coupled between the terminal of the second inductor and the second power splitter output terminal.

As will be appreciated by one skilled in the art, aspects of the present disclosure may be embodied as a system, process, method, and/or program product. Accordingly, various aspects of the present disclosure may take the form of an entirely hardware embodiment or embodiments combining software and hardware aspects, which may generally be referred to herein as a "circuit," "circuitry," "module," or "system."

The block diagrams in the figures illustrate architecture, functionality, and operation of possible implementations of circuitry, systems, methods, processes, and program products according to various embodiments of the present disclosure. In this regard, certain blocks in the block diagrams may represent a module, segment, or portion of. It should also be noted that, in some implementations, the functions noted in the blocks may occur out of the order noted in the figures.

The preceding detailed description is merely illustrative in nature and is not intended to limit the embodiments of the subject matter or the application and uses of such embodiments.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "coupled" or "coupled" together. As used herein, unless expressly stated otherwise, "coupled" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter, except where specifically stated to the contrary.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

**Claims**

1. A Doherty power amplifier, comprising:

   a power splitter including a power splitter input terminal, a first power splitter output terminal having a first output impedance, and a second power splitter output terminal having a second output impedance that is different from the first output impedance, wherein the power splitter is an asymmetric Wilkinson power splitter configured to receive a first amplified signal at the power splitter input terminal, split the first amplified signal into a carrier signal and a peaking signal, output the carrier signal at the first power splitter output terminal, and output the peaking signal at the second power splitter output terminal;
   a carrier amplifier die including a carrier amplifier input terminal and a carrier amplifier output terminal, wherein the carrier amplifier input terminal is electrically coupled to the first power splitter output terminal, and the carrier amplifier die is configured to receive the carrier signal at the carrier amplifier input terminal and generate an amplified carrier signal based on the carrier signal at the carrier amplifier output terminal;
   a peaking amplifier die including a peaking amplifier input terminal and a peaking amplifier output terminal, wherein the peaking amplifier input terminal is electrically coupled to the second power splitter output terminal, and the peaking amplifier die is configured to receive the peaking signal at the peaking amplifier input terminal and generate an amplified peaking signal based on the peaking signal at the peaking amplifier output terminal; and
   a combining node electrically coupled to the carrier amplifier output terminal and the peaking amplifier output terminal, wherein the combining node is configured to receive and combine the amplified carrier signal and the amplified peaking signal to produce an amplified output radio frequency signal.

2. The Doherty power amplifier of claim 1, wherein a power level of the peaking signal is greater than a power level of the carrier signal.

3. The Doherty power amplifier of claim 2, wherein the power level of the peaking signal is from 1.6 to 2.2 times greater than the power level of the carrier signal and a volume of the peaking amplifier die is at least 1.6 times greater than a volume of the carrier amplifier die.

4. The Doherty power amplifier of any preceding claim, wherein the first output impedance is greater than the second output impedance.

5. The Doherty power amplifier of claim 3 or 4, wherein the output impedance of the first power splitter output terminal is between 25 ohms and 35 ohms and the output impedance of the second power splitter output terminal is between 10 ohms and 20 ohms.

6. The Doherty power amplifier of any preceding claim, wherein the first power splitter output terminal is directly electrically coupled to the carrier amplifier input terminal.

7. The Doherty power amplifier of claim 6, wherein the second power splitter output terminal is directly electrically coupled to the peaking amplifier input terminal.

8. The Doherty power amplifier of any preceding claim, wherein the power splitter includes a first leg between the power splitter input terminal and the first power splitter output terminal, and a second leg between the power splitter input terminal and the second power splitter output terminal, wherein the first leg includes a first inductor and the second leg include a second inductor, and further including a balance resistor coupled between a terminal of the first inductor and a terminal of the second inductor, wherein the balance resistor is configured to provide isolation between the first power splitter output terminal and the second power splitter output terminal.

9. The Doherty power amplifier of claim 8, wherein the first leg includes a variable phase advance circuit coupled between the terminal of the first inductor and the first power splitter output terminal.

10. The Doherty power amplifier of claim 9, wherein the second leg includes a variable phase lag circuit coupled between the terminal of the second inductor and the second power splitter output terminal, wherein the variable phase advance circuit is configured differently from the variable phase lag circuit.

11. The Doherty power amplifier of any preceding claim, further comprising:

an input terminal configured to receive an input radio frequency signal; and
a driver amplifier including a driver input terminal and a driver output terminal, wherein the driver amplifier is configured to receive the input radio frequency signal at the driver input terminal and output the first amplified signal at the driver output terminal.

12. An integrated passive device, for use in a Doherty power amplifier as claimed in any preceding claim and comprising:

a substrate; and
a power splitter a as defined in claim 1.

13. The integrated passive device of claim 12, wherein a power level of the second output signal is greater than a power level of the first output signal.

14. The integrated passive device of claim 13, wherein the power level of the second output signal is from 1.6 to 2.2 times greater than the power level of the first output signal.

15. The integrated passive device of any of claims 12 to 14, wherein the power splitter includes a first leg between the power splitter input terminal and the first power splitter output terminal, and a second leg between the power splitter input terminal and the second power splitter output terminal, wherein the first leg includes a first spiral inductor on the substrate and the second leg includes a second spiral inductor on the substrate, and further including a balance resistor coupled between a terminal of the first spiral inductor and a terminal of the second spiral inductor.

FIG. 1

FIG. 2

FIG. 3

FIG. 4

EP 4 633 036 A1

FIG. 5B

FIG. 5A

570

586
581 L4
C5 583
C4 580
Rbalance 579
582
587 C7
C6
584
L5
585
L2 578
L3 577
C2 575
C3 576
L1
574
C1
572
573

**FIG. 5C**

FIG. 6

EP 4 633 036 A1

Europäisches
Patentamt

European
Patent Office

Office européen
des brevets

# EUROPEAN SEARCH REPORT

**Application Number**

EP 25 15 9926

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/235734 A1 (PENGELLY RAYMOND SYDNEY [US]) 20 September 2012 (2012-09-20) * paragraph [0042] - paragraph [0067]; figures 5-7B * | 1-15 | INV. H03F1/02 H01P5/12 H03F1/56 H03F3/195 |
| X | US 2013/194023 A1 (AHMED ABDULRHMAN M S [US] ET AL) 1 August 2013 (2013-08-01) * paragraph [0015] - paragraph [0039]; figures 1-4 * | 1-15 | H03F3/24 |
| A | EP 3 817 223 A1 (NXP USA INC [US]) 5 May 2021 (2021-05-05) * paragraph [0007] - paragraph [0074]; figures 1-3 * | 1-15 | |

**TECHNICAL FIELDS SEARCHED (IPC)**

H03F
H01P

The present search report has been drawn up for all claims

| Place of search | Date of completion of the search | Examiner |
|---|---|---|
| The Hague | 17 July 2025 | Wienema, David |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 9926

This annex lists the patent family members relating to the patent documents cited in the above-mentioned European search report.
The members are as contained in the European Patent Office EDP file on
The European Patent Office is in no way liable for these particulars which are merely given for the purpose of information.

17-07-2025

| Patent document cited in search report | Publication date | Patent family member(s) | | Publication date |
|---|---|---|---|---|
| US 2012235734 A1 | 20-09-2012 | CN | 103415993 A | 27-11-2013 |
| | | EP | 2686953 A2 | 22-01-2014 |
| | | JP | 6523601 B2 | 05-06-2019 |
| | | JP | 6707602 B2 | 10-06-2020 |
| | | JP | 2014511166 A | 12-05-2014 |
| | | JP | 2019033500 A | 28-02-2019 |
| | | KR | 20140010952 A | 27-01-2014 |
| | | US | 2012235734 A1 | 20-09-2012 |
| | | US | 2014240039 A1 | 28-08-2014 |
| | | WO | 2012125279 A2 | 20-09-2012 |
| US 2013194023 A1 | 01-08-2013 | CN | 103227613 A | 31-07-2013 |
| | | EP | 2621085 A2 | 31-07-2013 |
| | | US | 2013194023 A1 | 01-08-2013 |
| | | US | 2013314143 A1 | 28-11-2013 |
| | | US | 2014253248 A1 | 11-09-2014 |
| | | US | 2015280665 A1 | 01-10-2015 |
| | | US | 2016294330 A1 | 06-10-2016 |
| | | US | 2017077874 A1 | 16-03-2017 |
| | | US | 2018159480 A1 | 07-06-2018 |
| | | US | 2018375477 A1 | 27-12-2018 |
| | | US | 2019181805 A1 | 13-06-2019 |
| EP 3817223 A1 | 05-05-2021 | CN | 111181496 A | 19-05-2020 |
| | | EP | 3817223 A1 | 05-05-2021 |
| | | US | 10868500 B1 | 15-12-2020 |

EPO FORM P0459

For more details about this annex : see Official Journal of the European Patent Office, No. 12/82